# EUROPÄISCHE PATENTSCHRIFT

(11) **EP 1 024 593 B1**
(45) Veröffentlichungstag und Bekanntmachung des Hinweises auf die Patenterteilung: **21.02.2007**
(21) Anmeldenummer: 00200236.8
(22) Anmeldetag: 21.01.2000
(51) Int. Cl.: H03H 1/00

(54) **Mehrkomponenten-Bauteil**
Multi-component mounting part
Composant à plusieurs éléments

(30) Priorität: 28.01.1999 DE 19903456
(43) Veröffentlichungstag der Anmeldung: 02.08.2000
(73) Patentinhaber: Philips Intellectual Property & Standards GmbH, 20099 Hamburg (DE); Koninklijke Philips Electronics N.V., 5621 BA Eindhoven (NL)
(72) Erfinder: Klee, Mareike, Philips Corp. Int. Property GmbH, 52064 Aachen (DE); Löbl, Peter, Philips Corp. Int. Property GmbH, 52064 Aachen (DE); Kiewitt, Rainer, Philips Corp. Int. Property GmbH, 52064 Aachen (DE); van Oppen, Paul, Philips Corp. Int. Property GmbH, 52064 Aachen (DE); Derksen, Rob J. A., Philips Corp. Int. Prop. GmbH, 52064 Aachen (DE); Brand, Hans-Wolfgang, Philips Corp. Int. Prop GmbH, 52064 Aachen (DE)
(74) Vertreter: Pennings, Johannes

(56) Entgegenhaltungen:
- EP-A- 0 789 390
- US-A- 4 675 644

## Beschreibung

Die Erfindung betrifft ein elektronisches Mehrkomponenten-Bauteil mit wenigstens einer ersten und einer zweiten Stromzuführung, sowie einer Substratschicht, einer darüberliegenden Widerstandsschicht, welche in Verbindung mit der ersten Stromzuführung steht, wenigstens einer darüberliegenden Dielektrikumschicht, und wenigstens einer darüberliegenden ersten Elektrode, welche mit der zweiten Stromzuführung verbunden ist.

Die Erfindung betrifft auch ein Mehrkomponenten-Bauteil mit wenigstens einer ersten und einer zweiten Stromzuführung, sowie einer Substratschicht, einer darüberliegenden ersten Elektrode und darüberliegend wenigstens eine erste und eine zweite Dielektrikumschicht alternierend mit wenigstens einer zweiten und dritten Elektrode.

In vielen elektronischen Schaltungen werden Spannungsversorgungen angewendet, welche in den meisten Anwendungen von den Wechselspannungssignalen entkoppelt werden müssen. In Verstärkerschaltungen für mobile Telefone, in der Umgebung von GaAs ICs sowie für die Störimpulsfilterung hochfrequenzgetakteter Mikroprozessoren werden heutzutage passive Bauelemente bestehend aus X7R-Kondensatoren, NP0-Kondensatoren und Widerständen eingesetzt. Bei vielen Schaltungen sind diskrete X7R-Kondensatoren und diskrete NP0-Kondensatoren parallel geschaltet. Bei einigen Schaltungen sind den X7R-Kondensatoren Widerstände in Serie geschaltet.

In Verstärkerschaltungen haben diese passiven Bauelemente unter anderem die Funktion, Störfrequenzen effizient aus den Versorgungsleitungen zu filtern, um eine konstante Versorgungsspannung zu garantieren. Diese Filterung im Bereich von einigen MHz bis zu einigen hundert MHz wird üblicherweise von einem X7R-Kondensator durchgeführt. Ein in Serie geschalteter Widerstand hat dabei die Funktion, Parallelresonanzen zu verhindern und ungewünschte Oszillationen zu vermeiden. Ein parallel zum X7R-Kondensator geschalteter NP0 Kondensator wird unter anderem eingesetzt, um Frequenzen von einigen hundert MHz, bevorzugt die Arbeitsfrequenz für die die Schaltung dimensioniert ist, aus der Gleichstromversorgungsleitung zu filtern.

Mit der steigenden Miniaturisierung tragbarer elektronischer Geräte und der steigenden Funktionalität dieser Systeme ist es nötig, die in den Schaltungen vorhandenen passiven Bauelemente zu miniaturisieren, um die Schaltungen so klein wie möglich zu gestalten.

Im Stand der Technik werden heutzutage weitgehend kleine diskrete, passive Bauelemente der Abmessung 0402 eingesetzt. Bei einer lateralen Abmessung vom 0.5 • 1 mm² für diese Bauelemente wird für jedes Einzelelement, trotz seiner kleinen Abmessungen durch das Auflöten auf der Platine dennoch ein erheblicher Platzbedarf benötigt. Gleichzeitig ist auch die Montage solch kleiner Bauelemente technisch aufwendig und teuer.

Aus Publikationsnummer 03203212 A der "Patent Abstracts of Japan" ist ein Verfahren zur Erhöhung der Packungsdichte von Schaltungselementen bekannt. In diesem Verfahren wird ein Kondensator auf die Oberfläche von einem willkürlichen passiven oder aktiven Chipteil montiert.

Eine weitere Möglichkeit Schaltungen zu miniaturisieren und Kosten zu senken, ist die Integration von passiven Bauelementen in IC's.

Der Erfindung liegt die Aufgabe zugrunde, die Bauelemente und dadurch bedingt auch die resultierenden Schaltungen weiter zu verkleinern und die Montage der Bauelemente zu erleichtern.

Die Aufgabe wird durch ein elektronisches Mehrkomponenten-Bauteil mit wenigstens einer ersten und einer zweiten Stromzuführung,
sowie einer Substratschicht,
einer darüberliegenden Widerstandsschicht, welche in Verbindung mit der ersten Stromzuführung steht,
wenigstens einer darüberliegenden Dielektrikumsschicht,
und wenigstens einer darüberliegenden ersten Elektrode, welche mit der zweiten Stromzuführung verbunden ist, gelöst.

Diese Anordnung hat den Vorteil, daß mit einem Widerstand und einem seriell geschalteten Kondensator zwei passive Bauelemente in einem einzigen Bauteil realisiert sind.

In einer bevorzugten Ausführung sind auf der ersten Elektrode eine weitere Dielektrikumschicht und eine zweite Elektrode, welche mit der ersten Stromzuführung verbunden ist, aufgebracht. In diesem Mehrkomponenten-Bauteil ist neben einem Widerstand und einem Kondensator noch ein weiterer Kondensator integriert.

In einer vorteilhaften Ausführungsform dieses Mehrkomponenten-Bauteils ist die zweite Elektrode mit der Widerstandsschicht verbunden. In dieser Ausführung des Mehrkomponenten-Bauteils ist der weitere Kondensator parallel zu den beiden anderen Bauelementen geschaltet.

In einer weiteren, bevorzugten Ausführung des Mehrkomponenten-Bauteils sind auf der ersten Elektrode eine zweite und dritte Dielektrikumschicht und eine zweite und dritte Elektrode alternierend-aufgebracht, wobei die zweite Elektrode mit der ersten Stromzuführung und die dritte Elektrode mit der zweiten Stromzuführung in Verbindung steht. In diesem Mehrkomponenten-Bauteil ist ein weiterer Kondensator integriert und somit sind insgesamt vier passive Bauelemente kombiniert.

In einer vorteilhaften Ausführungsform dieses Mehrkomponenten-Bauteils ist die zweite Elektrode mit der Widerstandsschicht und die dritte Elektrode ist mit der ersten Elektrode verbunden. Dadurch sind der zweite und dritte Kondensator parallel zum Widerstand und dem ersten Kondensator geschaltet, welche in Serie geschaltet sind.

Es ist bevorzugt, daß die Widerstandsschicht aus einem Material mit einem Metall oder einer Legierung oder einem leitenden Oxid oder einem Metall und einer Legierung oder einem Metall und einem leitenden Oxid oder einem Metall, einer Legierung und einem leitenden Oxid oder einem leitenden Metallnitrid ist. Die Materialien werden nach der Abscheidung beispielsweise mittels lithographischer Prozesse verbunden mit Naß- und Trockenätzschritten zu einer Widerstandsschicht strukturiert.

Es kann bevorzugt sein, daß die Elektroden widerstandsbehaftet sind und aus einem Material mit einem Metall oder einer Legierung oder einem leitenden Oxid oder einem Metall und einer Legierung oder einem Metall und einem leitenden Oxid oder einem Metall, einer Legierung und einem leitenden Oxid oder einem leitenden Metallnitrid ist. Die Materialien werden nach dem Aufbringen auf die Dielektrikumschicht beispielsweise mittels lithographischer Prozesse verbunden mit Naß- und Trockenätzschritten zu einer widerstandsähnlichen Schicht strukturiert. In dieser Ausführung beinhalten die Mehrkomponenten-Bauteile mehrere Widerstände, die gleichzeitig die Elektroden der Kondensatoren bilden.

Es ist weiterhin bevorzugt, daß die über der Widerstandsschicht liegende erste Dielektrikumschicht eine Dielektrizitätskonstante von K > 7 aufweist. Durch die hohe Dielektrizitätskonstante der Dielektrikumschicht werden an diesem Kondensator hohe Kapazitäten auf kleinen Abmessungen erreicht.

In den bevorzugten Ausführungen des Mehrkomponenten-Bauteils ist vorgesehen, daß die zweite und dritte Dielektrikumschicht eine Dielektrizitätskonstante von K > 3 besitzen. Der zweite und dritte Kondensator weisen geringere Kapazitäten auf

Des weiteren betrifft die Erfindung ein elektronisches Mehrkomponenten-Bauteil mit wenigstens einer ersten und einer zweiten Stromzuführung,
sowie einer Substratschicht,
wenigstens einer darüberliegenden ersten Elektrode, welche mit der ersten Stromzuführung verbunden ist,
und darüberliegend wenigstens eine erste und eine zweite Dielektrikumschicht alternierend mit wenigstens einer zweiten und dritten Elektrode, wobei die zweite Elektrode mit der zweiten Stromzuführung und die dritte Elektrode mit der ersten Stromzuführung verbunden ist.

Dieses Mehrkomponenten-Bauteil hat den Vorteil, daß zwei passive Bauelemente, in diesem Fall zwei Kondensatoren, in einem Bauteil übereinander realisiert sind.

Eine bevorzugte Ausführungsform dieses Mehrkomponenten-Bauteiles sieht vor, daß die erste und zweite Dielektrikumschicht jeweils aus einem dielektrischen Material mit gleichen dielektrischen Eigenschaften sind.

Es kann außerdem bevorzugt sein, daß die erste und zweite Dielektrikumschicht aus dielektrischen Materialien mit unterschiedlichen dielektrischen Eigenschaften bestehen, wobei die Dielektrizitätskonstante der ersten Dielektrikumschicht größer als die Dielektrizitätskonstante der zweiten Dielektrikumschicht ist.

Je nach Anwendung und Art der Schaltung können somit Kondensatoren mit den erforderlichen Kapazitäten und Eigenschaften hergestellt und eingesetzt werden.

Es ist vorteilig, daß in allen Mehrkomponenten-Bauteilen die Substratschicht ein keramisches Material, ein keramisches Material mit einer Planarisierung aus Glas, ein glaskeramisches Material, ein Glasmaterial oder Silicium enthält. Eine Substratschicht aus einem keramischen oder aus einem keramischen Material mit einer Planarisierung aus Glas oder aus einem glaskeramischen Material oder aus einem Glassubstrat ist kostengünstig herzustellen und die Prozeßkosten für diese Komponente können niedrig gehalten werden. Bei Integration der Mehrkomponenten-Bauteile in IC's ist die Substratschicht aus Silicium und ist gegebenenfalls mit einer Passivierungsschicht aus SiO₂ versehen.

Es kann bevorzugt sein, daß die Elektroden aus einem Material mit einem Metall oder einer Legierung oder einem leitenden Oxid oder einem Metall und einer Legierung oder einem Metall und einem leitenden Oxid oder einem Metall, einer Legierung und einem leitenden Oxid oder einem leitenden Metallnitrid sind. Diese Materialien werden nach der Abscheidung auf die Dielektrikumschichten beispielsweise mittels lithographischer Prozesse verbunden mit Naß- und Trockenätzschritten zu Elektroden strukturiert.

An den Stromzuführungen, welche meist an gegenüberliegenden Seiten des Bauteiles angebracht sind, kann jedes Mehrkomponenten-Bauteil mit weiteren Bauelementen des Schaltkreises elektrisch gekoppelt werden. Je nach Art der Applikation oder Art der Bauteilmontage kann als Stromzuführung ein galvanischer SMD-Endkontakt oder ein Bump-end-Kontakt oder eine Kontaktfläche eingesetzt werden. Durch die Verwendung von SMD-Endkontakten beispielsweise aus Cr/Cu, Ni/Sn oder Cr/Cu, Cu/Ni/Sn oder Cr/Ni, Pb/Sn oder Bump-end-Kontakten können diskrete Mehrkomponenten-Bauteile hergestellt werden während der Einsatz von Kontaktflächen die Integration der Mehrkomponenten-Bauteile in IC's ermöglicht.

Es kann außerdem bevorzugt sein, daß sich in allen Mehrkomponenten-Bauteilen auf der Substratschicht eine Barriereschicht befindet, um bei oberflächenrauhen Substratschichtmaterialien eine Reaktion mit dem Dielektrikum oder Kurzschlüsse zu vermeiden.

Es kann außerdem bevorzugt sein, daß über dem gesamten Mehrkomponenten-Bauteil eine Schutzschicht aus einem anorganischen und/oder einem organischen Material aufgebracht ist. Durch die Schutzschicht werden die darunterliegenden Schichten vor mechanischer Beanspruchung geschützt.

Es kann ebenso bevorzugt sein, daß auf der Schutzschicht eine Glasschicht oder eine Glasplatte aufgebracht ist. Diese zusätzliche Schicht schützt das Mehrkomponenten-Bauteil vor Feuchtigkeit und Korrosion.

Im folgenden soll die Erfindung anhand dreier Figuren und dreier Ausführungsbeispiele erläutert werden. Dabei zeigt
- Fig. 1:: im Querschnitt den schematischen Aufbau eines Mehrkomponenten-Bauteiles, welches einen Widerstand und zwei Kondensatoren enthält,
- Fig. 2:: im Querschnitt den schematischen Aufbau eines Mehrkomponenten-Bauteiles, welches zwei Widerstände und drei Kondensatoren enthält und
- Fig. 3:: im Querschnitt den schematischen Aufbau eines Mehrkomponenten-Bauteiles, welches zwei Kondensatoren enthält.

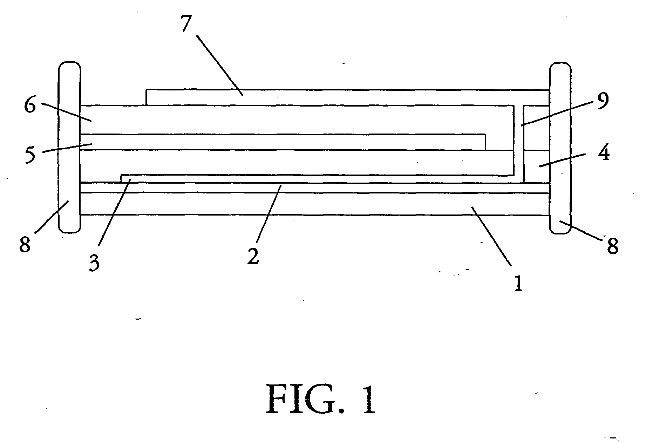

Gemäß Fig. 1 weist ein Mehrkomponenten-Bauteil eine Substratschicht 1 auf, welche zum Beispiel aus einem keramischen Material, einem keramischen Material mit Planarisierung aus Glas, einem glaskeramischen Material, einem Glasmaterial oder Silicium ist. Auf der Substratschicht 1 ist eine Barriereschicht 2 beispielsweise aus TiO₂, Al₂O₃ oder ZrO₂ und eine Widerstandsschicht 3 aufgebracht, die auch als Elektrode dient. Diese Widerstandsschicht 3 kann beispielsweise eine Schicht aus Ti (10 bis 20 nm)/Pt (20 bis 600 nm), Ti (10 bis 20 nm)/Pt (20 bis 600 nm)/Ti (5 bis 20 nm), Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ x ≤ 1), Ti/RuOₓ (0 ≤ x ≤ 2), RuOₓ (0 ≤ x ≤ 2), Ti/Ir/IrOₓ (0 ≤ x ≤ 2), IrOₓ(0 ≤ x ≤ 2), RhOₓ (0 ≤ x ≤ 2), NiₓCr_{y} (0 ≤ x ≤ 1, 0 ≤ y ≤ 1), NiₓCr_{y}Al_{z} (0 ≤ x ≤ 1, 0 ≤ y ≤ 1, 0 ≤ z ≤ 1), TiₓW_{y}N₂ (0 ≤ x ≤ 1, 0 ≤ y ≤ 1, 0 ≤ z ≤ 1), TaₓN_{y}(0 ≤ x ≤ 1, 0 ≤ y ≤ 1), SiₓCr_{y}O₂ (0 ≤ x ≤ 1, 0 ≤ y ≤ 1, 0 ≤ z ≤ 1), SiₓCr_{y}N₂ (0 ≤ x ≤ 1, 0 ≤ y ≤ 1, 0 ≤ z ≤ 1), Polysilicium,TiₓW_{y} (0 ≤ x ≤ 1, 0 ≤ y ≤ 1), CuₓNi_{y} (0 ≤ x ≤ 1, 0 ≤ y ≤ 1), Pt (50 nm bis 1 µm), Al dotiert mit einigen Prozent Cu, Ti/Pt/Al, Ti/Ag, Ti/Ag/Ti, Ni, Cu, Ti/Ag/Ir, Ti/Ir, Ti/Pd, Ti/Ag/Pt₁₋ₓAlₓ (0 ≤ x ≤ 1), Ti/Ag/Ru, Ti/Ag/Ir/IrOₓ (0 ≤ x ≤ 2), Ti/Ag/Ir, Ti/Ag/Ru/RuOₓ (0 ≤ x ≤ 2), Ti/Ag/Ru/RuₓPt₁₋ₓ (0 ≤ x ≤ , Ti/Ag/RuₓPt₁₋ₓ/RuO_{y} (0 ≤ x ≤ 1, 0 ≤ y ≤ 2), Ti/Ag/Ru/RuOₓRu_{y}Pt_{1-y} (0 ≤ x ≤ 2, 0 ≤ y ≤ 1), Ti/Ag/RuₓPt₁₋ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1), Ti/Ag/Pt_{y}(RhOₓ)_{1-y} (0 ≤ x ≤ 2, 0 ≤ y ≤ 1), Ti/Ag/Rh/RhOₓ (0 ≤ x ≤ 2), Ti/Ag/PtₓRh₁₋ₓ (0 ≤ x ≤ 1), Ti/Ag/Pr_{y}(RhOₓ)_{1-y}/Pt_{z}Rh_{1-z} (0 ≤ x ≤ 2, 0 ≤ y ≤ 1, 0 ≤ z ≤ 1), Ti/AgₓPt₁₋ₓ/Ir (0 ≤ x ≤ 1), Ti/AgₓPt₁₋ₓ/Ir/IrO_{y} (0 ≤ x ≤ 1, 0 ≤ y ≤ 2), Ti/AgₓPt₁₋ₓ/Pt_{y}Al_{1-y} (0 ≤ x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Ni/Al/ITO, Ti/Ni, Ti/Cu, ITO oder Ti/ITO sein. Auf dieser Widerstandsschicht 3 ist eine Dielektrikumschicht 4 mit einer Dielektrizitätskonstanten von K > 7 aufgebracht, die beispielsweise PbZrₓTi₁₋ₓO₃ (x = 0 bis 1) mit und ohne Bleiüberschuß, Pb_{1-αy}La_{y}ZrₓTi₁₋ₓO₃ (0 ≤ x ≤ 1,0 ≤ y ≤ 0.2, 1.3 ≤ α ≤ 1.5), Pb_{1-αx}LaₓTiO₃ (0 ≤ x ≤ 0.3, 1.3 ≤ α ≤ 1.5), (Pb,Ca)TiO₃, BaTiO₃, BaTiO₃ mit Ce Dotierung, BaTiO₃ mit Nb und/oder Co Dotierung, BaZrₓTi₁₋ₓO₃ (0 ≤ x ≤ 1), Ba₁₋ₓPbₓTiO₃ (0 ≤ x ≤ 1), Ba_{1-y}Sr_{y}ZrₓTi₁₋ₓO₃ (0 ≤ x ≤ 1, 0 ≤ y ≤ 1), Ba₁₋ₓSrₓTiO₃ (0 ≤ x ≤ 1) mit und ohne Mn-Dotierungen, SrTiO₃ mit Dotierungen von zum Beispiel La, Nb, Fe oder Mn, SrZrₓTi₁₋ₓO₃ (0 ≤ x ≤ 1), CaOₓZnO_{y}(Nb₂O₅)_{z} (x = 0.01 bis 0.05, y = 0.43 bis 0.55, z = 0.44 bis 0.52), (BaTiO₃)_{0.18 bis 0.27} + (Nd₂O₃)_{0.316 bis 0.355} + (TiO₂)_{0.276 bis 0.355} + (Bi₂O₃)_{0.025 bis 0.081} + x ZnO, CaTiO₃ + CaTiSiO₅, (Sr,Ca)(Ti,Zr)O₃, (Sr,Ca,M)(Ti,Zr)O₃ (M = Mg oder Zn), (Sr,Ca,Mg,Zn)(Ti,Zr,Si)O₃, (Sr,Ca,Cu,Mn,Pb)TiO₃ + Bi₂O₃, BaO-TiO₂-Nd₂O₃-Nb₂O₅, (Bi₂O₃)ₓ(Nb₂O₅)₁₋ₓ und Zugaben von SiO₂, MnO₂ bzw. PbO, BaTiO₃ mit Nb₂O₅, CoO, CeO₂, ZnO und Oxide des Mangans als Dotierungen, BaTiO₃ + CaZrO₃, Zugaben von MnO₂, MgO und Seltenerdoxiden, (Ba,Ca)TiO₃ + Nb₂O₅, Co₂O₃ bzw. MnO₂, Ba₂Ti₉O₂₀, Ba₂Ti₉₋ₓZrₓO₂₀ (x = 0 bis 1) mit und ohne Mn-Dotierungen, BaTi₅O₁₁, BaTi₄O₉, CaₓSm_{y}Ti_{z}Oₙ (0 ≤ x ≤ 1, 0 ≤ y ≤ 1, 0 ≤ z ≤ 1, 0 ≤ n ≤ 1), Zr(Ti,Sn)O₄, TiO₂, Ta₂O₅, (Ta₂O₅)ₓ-(Al₂O₃)₁₋ₓ (0 ≤ x ≤ 1), (Ta₂O₅)ₓ-(TiO₂)₁₋ₓ (0 ≤ x ≤ 1), (Ta₂O₅)ₓ-(Nb₂O₅)₁₋ₓ (0 ≤ x ≤ 1), (Ta₂O₅)ₓ-(SiO₂)₁₋ₓ (0 ≤ x ≤ 1), BaO-PbO-Nd₂O₃-TiO₂, Ba(Zn,Ta)O₃, BaZrO₃, CaZrO₃, Nd₂Ti₂O₇, (Ba,Ca,Sr)(Ti,Zr)O₃ + Li₂O, SiO₂, B₂O₃, [Bi₃(Ni₂Nb)O₉]₁₋ₓ-(Bi₂(ZnNb_{2(1+d)y}O_{3+6y+5yd})ₓ (0 ≤ x ≤ 1, 0.5 ≤ y ≤ 1.5, -0.05 ≤ d ≤ 0.05), PbNb_{4/5x}((Zr_{0.6}Sn_{0.4})_{1-y}Ti_{y}))₁₋ₓO₃ (0 ≤ x ≤ 0.9, 0 ≤ y ≤ 1), [Pb(Mg_{1/3}Nb_{2/3})O₃]ₓ-(PbTiO₃)₁₋ₓ (x = 1 bis 0), (Pb,Ba,Sr) (Mg_{1/3}Nb_{2/3})ₓTi_{y}(Zn_{1/3}Nb_{2/3})_{1-x-y}O₃ (0 ≤ x ≤ 1, 0 ≤ y ≤ 1, x+y ≤ 1),
i) Pb(Mg_{0.5}W_{0.5})O₃
ii) Pb(Fe_{0.5}Nb_{0.5})O₃
iii) Pb(Fe_{2/3}W_{1/3})O₃ iv) Pb(Ni_{1/3}Nb_{2/3})O₃
v) Pb(Zn_{1/3}Nb_{2/3})O₃
vi) Pb(Sc_{0.5}Ta_{0.5})O₃
sowie Kombinationen der Verbindungen i) bis vi) mit PbTiO₃ und/oder Pb(Mg_{1/3}Nb_{2/3})O₃ mit und ohne Bleiüberschuß enthält. Auf dieser Dielektrikumschicht 4 sind eine erste Elektrode 5, darüber eine Dielektrikumschicht 6 und darüber eine zweite Elektrode 7 aufgebracht. Das Material der Elektroden 5 und 7 kann beispielsweise aus Pt, Ti (10 bis 20 nm)/Pt (20 bis 600 nm), Ti (10 bis 20 nm)/Pt (20 bis 600 nm)/Ti (5 bis 20 nm), Al, Al mit einigen Prozent Cu, Al mit einigen Prozent Mg, Al mit einigen Prozent Si, Ti/Pt/Al, Ti/Ag, Ti/Ag/Ti, Ni, Cu, Ti/Ag/Ir, Ti/Ir, Ti/Pd, Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ x ≤ 1), Ti/Ag/Pt₁₋ₓAl (0 ≤ x ≤ 1), Ti/Ag/Ru, Ti/Ag/Ir/IrOₓ (0 ≤ x ≤ 2), Ti/Ag/Ru/RuOₓ (0 ≤ x ≤ 2), Ti/Ag/Ru/RuₓPt₁₋ₓ (0 ≤ x ≤ 1), Ti/Ag/Ru/RuₓPt₁₋ₓ/RuO_{y}, (0 ≤ x ≤ 1,0 ≤ y ≤ 2), Ti/Ag/Ru/RuOₓ/Ru_{y}Pt_{1-y} (0 ≤ x ≤ 2, 0 ≤ y ≤ 1), Ti/Ag/RuₓPt₁₋ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1), Ti/Ag/Pt_{y}(RhOₓ)_{1-y} (0 ≤ x ≤ 2, 0 ≤ y ≤ 1), Ti/Ag/Rh/RhOₓ (0 ≤ x ≤ 2), Ti/Ag/PtₓRh₁₋ₓ (0 ≤ x ≤ 1), Ti/Ag/Pt_{y}(RhOₓ)_{1-y}/Pt_{z}Rh_{1-z} (0 ≤ x ≤ 2,0 ≤ y ≤ 1, 0 ≤ z ≤ 1), Ti/AgₓPt₁₋ₓ/Ir (0 ≤ x ≤ 1), Ti/AgₓPt₁₋ₓ/Ir/IrO_{y} (0 ≤ x ≤ 1, 0 ≤ y ≤ 2), Ti/AgₓPt₁₋ₓ/Pt_{y}Al_{1-y} (0 x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO, Ti/Ni/Al/ITO, Ti/Ni, Ti/Cu, NiₓCr_{y} (0 ≤ x ≤ 1, 0 ≤ y ≤ 1), NiₓCr_{y}Al_{z} (0 ≤ x ≤ 1, 0 ≤ y ≤ 1, 0 ≤ z ≤ 1), TiₓW_{y}N_{z} (0 ≤ x ≤ 1, 0 ≤ y ≤ 1, 0 ≤ z ≤ 1), TaₓN_{y} (0 ≤ x ≤ 1, 0 ≤ y ≤ 1), SiₓCr_{y}O_{z} (0 ≤ x ≤ 1, 0 ≤ y ≤ 1, 0 ≤ z ≤ 1), SiₓCr_{y}N_{z} (0 ≤ x ≤ 1, 0 ≤ y ≤ 1, 0 ≤ z ≤ 1), TiₓW_{y} (0 ≤ x ≤ 1, 0 ≤ y ≤ 1) oder CuₓNi_{y} (0 ≤ x ≤ 1, 0 ≤ y ≤ 1) sein. Die Dielektrikumschicht 6 besitzt eine Dielektrizitätskonstante von K > 3 und ist zum Beispiel aus Si₃N₄, SiO₂, SiₓN_{y}O_{z} (0 ≤ x ≤ 1, 0 ≤ y ≤ 1, 0 ≤ z ≤ 1), Al₂O₃, Ta₂O₅, (Ta₂O₅)ₓ-(Al₂O₃)₁₋ₓ (0 ≤ x ≤ 1), (Ta₂O₅)ₓ-(TiO₂)₁₋ₓ (0 ≤ x ≤ 1), (Ta₂O₅)ₓ-(Nb₂O₅)₁₋ₓ (0 ≤ x ≤ 1), (Ta₂O₅)ₓ-(SiO₂)₁₋ₓ (0 ≤ x ≤ 1), TiO₂, SrZrₓTi₁₋ₓO₃ (0 ≤ x ≤ 1) mit und ohne Mn-Dotierungen, CaOₓZnO_{y}(Nb₂O₅)_{z} (x = 0.01 bis 0.05, y = 0.43 bis 0.55, z = 0.44 bis 0.52), (BaTiO₃)_{0.18 bis 0.27} + (Nd₂O₃)_{0.316 bis 0.355} + (TiO₂)_{0.276 bis 0.355} + (Bi₂O₃)_{0.025 bis 0.081} + x ZnO, CaTiO₃ + CaTiSiO₅, (Sr,Ca)(Ti,Zr)O₃, (Sr,Ca,M) (Ti,Zr)O₃ (M = Mg oder Zn), (Sr,Ca,Mg,Zn)(Ti,Zr,Si)O₃, (Sr,Ca,Cu,Mn,Pb)TiO₃ + Bi₂O₃, BaO-TiO₂-Nd₂O₃-Nb₂O₅, Zr(Ti,Sn)O₄, BaO-PbO-Nd₂O₃-TiO₂, Ba(Zn,Ta)O₃, BaZrO₃, Ba₂Ti₉O₂₀, Ba₂Ti₉₋ₓZrₓO₂₀ (0 ≤ x ≤ 1) mit und ohne Mn-Dotierungen, BaTi₅O₁₁, BaTi₄O₉, CaₓSm_{y}Ti_{z}Oₙ (0 ≤ x ≤ 1, 0 ≤ y ≤ 1, 0 ≤ z ≤ 1, 0 ≤ n ≤ 1), [Bi₃(Ni₂Nb)O₉]₁₋ₓ-(Bi₂(ZnNb_{2(1+d)y}O_{3+6y+5yd})ₓ (0 ≤ x ≤ 1, 0.5 ≤ y ≤ 1.5, -0.05 ≤ d ≤ 0.05), CaZrO₃ oder Nd₂Ti₂O₇. Außerdem sind an gegenüberliegenden Seiten des Mehrkomponenten-Bauteiles Stromzuführungen 8 befestigt. Als Stromzuführung 8 kann ein galvanischer SMD-Endkontakt aus beispielsweise Cr/Cu, Ni/Sn oder Cr/Cu, Cu/Ni/Sn oder Cr/Ni, Pb/Sn oder ein Bump-end-Kontakt oder eine Kontaktfläche eingesetzt werden. Die zweite Elektrode 7 ist über ein Via 9 in den Dielektrikumschichten 4 und 6 mittels beispielsweise Aluminium, Aluminium dotiert mit Kupfer, Kupfer, Platin oder Nickel mit der Widerstandsschicht 3 verbunden.

Alternativ kann über dem gesamten Mehrkomponenten-Bauteil eine Schutzschicht aufgebracht werden, die ein anorganisches Material wie beispielsweise Si₃N₄ oder SiO₂ und/oder ein organisches Material wie zum Beispiel Polyimid oder Polybenzocyclobuten enthält.

Außerdem kann auf der Schutzschicht eine Glasschicht oder Glasplatte aufgebracht werden.

Der Kontakt zwischen der zweiten Elektrode 7 und der Widerstandsschicht 3 kann auch hergestellt werden, indem vor dem Aufbringen des Materials für die zweite Elektrode 7 Teile der Dielektrikumschichten 4 und 6 auf einer Seite des Mehrkomponenten-Bauteiles beispielsweise durch Ätzen entfernt werden. Beim Aufbringen des Materials für die zweite Elektrode 7 wird ein Kontakt mit der freiliegenden Widerstandsschicht 3 hergestellt.

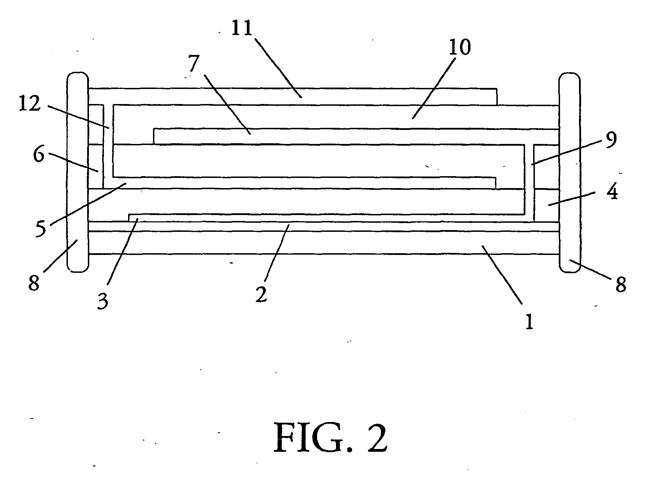

Fig. 2 weist den analogen Grundaufbau wie in Fig. 1 beschrieben auf besitzt aber zusätzlich noch eine dritte Dielektrikumschicht 10 und eine dritte Elektrode 11. Dabei weist die Dielektrikumschicht 10 eine Dielektrizitätskonstante von K > 3 auf und kann dieselben Materialien wie die Dielektrikumschicht 6 enthalten. Die dritte Elektrode 11 enthält dieselben Materialien wie die zweite Elektrode 7. Die dritte Elektrode 11 ist über ein Via 12 durch die Dielektrikumschichten 6 und 10 mit der ersten Elektrode 5 mittels beispielsweise Aluminium, Aluminium dotiert mit Kupfer, Kupfer, Platin oder Nickel verbunden.

Die Elektrode 5, 7 und 11 können auch widerstandsbehaftet und widerstandsähnlich ausgebildet sein. Sie können zusätzlich zu den oben angegebenen Materialien auch beispielsweise Polysilicium enthalten.

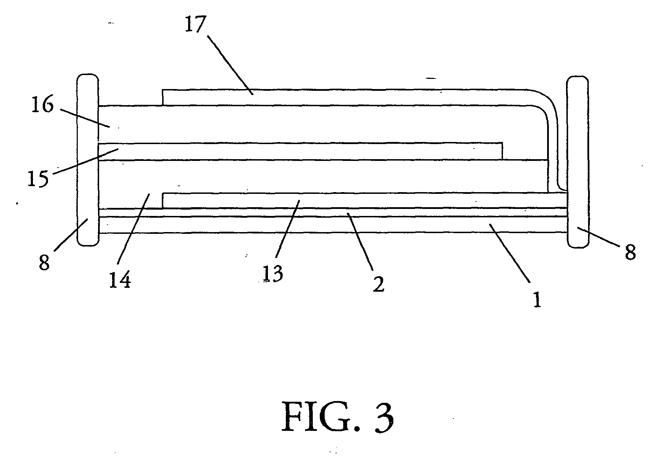

Gemäß Fig. 3 weist ein Mehrkomponenten-Bauteil eine Substratschicht 1 auf, welche aus einem keramischen Material, einem keramischen Material mit einer Planarisierung aus Glas, einem glaskeramischen Material, einem Glasmaterial oder Silicium ist. Auf der Substratschicht 1 sind übereinander eine Barriereschicht 2 aus beispielsweise TiO₂, Al₂O₃ oder ZiO₂, eine erste Elektrode 13, eine Dielektrikumschicht 14, eine zweite Elektrode 15, eine Dielektrikumschicht 16 und eine dritte Elektrode 17 aufgebracht. Das Elektrodenmaterial der Elektroden 13, 15 und 17 kann beispielsweise Pt, Ti (10 bis 20 nm)/Pt (20 bis 600 nm), Ti (10 bis 20 nm)/Pt (20 bis 600 nm)/Ti (5 bis 20 nm), Al, Al dotiert mit Cu, Al dotiert mit Mg, Al dotiert mit Si, Ti/Pt/Al, Ti/Ag, Ti/Ag/Ti, Ni, Cu, Ti/Ag/Ir, Ti/Ir, Ti/Pd, Ti/Ag₁₋ₓPtₓ (0 ≤ x ≤ 1), Ti/Ag₁₋ₓPdₓ (0 ≤ x ≤ 1), Ti/Pt₁₋ₓAlₓ (0 ≤ x ≤ 1), Pt₁₋ₓAlₓ (0 ≤ x ≤ 1), Ti/Ag/Pt₁₋ₓAlₓ (0 ≤ x ≤ 1), Ti/Ag/Ru, Ti/Ag/Ir/IrOₓ (0 ≤ x ≤ 2), Ti/Ag/Ru/RuOₓ (0 ≤ x ≤ 2), Ti/Ag/Ru/RuₓPt₁₋ₓ (0 ≤ x ≤ 1), Ti/Ag/Ru/RuₓPt₁₋ₓ/RuO_{y} (0 ≤ x ≤ 1, 0 ≤ y ≤ 2), Ti/Ag/Ru/RuOₓ/Ru_{y}Pt_{1-y} (0 ≤ x ≤ 2, 0 ≤ y ≤ 1), Ti/Ag/RuₓPt₁₋ₓ (0 ≤ x ≤ 1), Ti/Ag/PtₓAl₁₋ₓ (0 ≤ x ≤ 1), PtₓAl₁₋ₓ/Ag/Pt_{y}Al_{1-y} (0 ≤ x ≤ 1, 0 ≤ y ≤ 1), Ti/Ag/Pt_{y}(RhOₓ)_{1-y} (0 ≤ x ≤ 2, 0 ≤ y ≤ 1), Ti/Ag/Rh/RhOₓ (0 ≤ x ≤ 2), Ti/Ag/PtₓRh₁₋ₓ (0 ≤ x ≤ 1), Ti/Ag/Pt_{y}(RhOₓ)_{1-y}/Pt_{z}Rh_{1-z} (0 ≤ x ≤ 2, 0 ≤ y ≤ 1, 0 ≤ z ≤ 1), Ti/AgₓPt₁₋ₓ/Ir (0 ≤ x ≤ 1), Ti/AgₓPt₁₋ₓ/Ir/IrO_{y} 0 ≤ x ≤ 1, 0 ≤ y ≤ 2), Ti/AgₓPt₁₋ₓ/Pt_{y}Al_{1-y} (0 ≤ x ≤ 1, 0 ≤ y ≤ 1), Ti/AgₓPt₁₋ₓ/Ru (0 ≤ x ≤ 1), Ti/AgₓPt₁₋ₓ/Ru/RuO_{y} (0 ≤ x ≤ 1, 0 ≤ y ≤ 2), Ti/Ag/Cr, Ti/Ag/Ti/ITO, Ti/Ag/Cr/ITO, Ti/Ag/ITO, Ti/Ni/ITO Ti/Ni/Al/ITO, Ti/Ni, Ti/Cu, NiₓCr_{y} (0 ≤ x ≤ 1, 0 ≤ y ≤ 1), NiₓCr_{y}Al_{z} (0 ≤ x ≤ 1, 0 ≤ y ≤ 1, 0 ≤ z ≤ 1), TiₓW_{y}N_{z} (0 ≤ x ≤ 1,0 ≤ y ≤ 1,0 ≤ z ≤ 1), TaₓN_{y} (0 ≤ x ≤ 1, 0 ≤ y ≤ 1), SiₓCr_{y}O_{z} (0 ≤ x ≤ 1,0 ≤ y ≤ 1, 0 ≤ z ≤ 1), SiₓCr_{y}N_{z} (0 ≤ x ≤ 1, 0 ≤ y ≤1, 0 ≤ z ≤ 1), TiₓW_{y} (0 ≤ x ≤ 1, 0 ≤ y ≤ 1) oder CuₓNi_{y} (0 ≤ x ≤ 1, 0 ≤ y ≤ 1) sein. Die Dielektrikumschichten 14 und 16 können jeweils ein dielektrisches Material mit gleichen dielektrischen Eigenschaften enthalten und dabei eine Dielektrizitätskonstante von K > 7 oder K > 3 haben. Oder die Dielektrikumschichten 14 und 16 enthalten dielektrische Materialien mit unterschiedlichen dielektrischen Eigenschaften, wobei die Dielektrizitätskonstante der Dielektrikumschicht 14 größer als die Dielektrizitätskonstante der Dielektrikumschicht 16 ist. Die Dielektrikumschichten mit einer Dielektrizitätskonstante von K > 7 können beispielsweise PbZrₓTi₁₋ₓO₃ (x = 0 bis 1) mit und ohne Bleiüberschuß, Pb_{1-αy}La_{y}ZrₓTi₁₋ₓO₃ (0 ≤ x ≤ 1, 0 ≤ y ≤ 0.2, 1.3 ≤ α ≤ 1.5), Pb_{1-αx}LaₓTiO₃ (0 ≤ x ≤ 0.3, 1.3 ≤ α ≤ 1.5), (Pb,Ca)TiO₃, BaTiO₃, BaTiO₃ mit Ce Dotierung, BaTiO₃ mit Nb und/oder Co Dotierung, BaZrₓTi₁₋ₓO₃ (0 ≤ x ≤ 1), Ba₁₋ₓPbₓTiO₃ (0 ≤ x ≤ 1), Ba_{1-y}Sr_{y}ZrₓTi₁₋ₓO₃ (0 ≤ x ≤ 1, 0 ≤ y ≤ 1), Ba₁₋ₓSrₓTiO₃ (x = 0 bis1) mit und ohne Mn-Dotierungen, SrTiO₃ mit Dotierungen von zum Beispiel La, Nb, Fe oder Mn, SrZrₓTi₁₋ₓO₃ (x = 0 bis 1) mit und ohne Mn-Dotierung, CaOₓZnO_{y}(Nb₂O₅)₂ (x = 0.01 bis 0.05, y = 0.43 bis 0.55, z = 0.44 bis 0.52), (BaTiO₃)_{0.18 bis 0.27} + (Nd₂O₃)_{0.316 bis 0.355} + (TiO₂)_{0.276 bis 0355} + (Bi₂O₃)_{0.025 bis 081}+ x ZnO, CaTiO₃ + CaTiSiO₅, (Sr,Ca)(Ti,Zr)O₃, (Sr,Ca,M)(Ti,Zr)O₃ (M = Mg oder Zn), (Sr,Ca,Mg,Zn) (Ti,Zr,Si)O₃, (Sr,Ca,Cu,Mn,Pb)TiO₃ + Bi₂O₃, BaO-TiO₂-Nd₂O₃-Nb₂O₅, (Bi₂O₃)ₓ(Nb₂O₅)₁₋ₓ und Zugaben von SiO₂, MnO₂ und PbO, BaTiO₃ mit Nb₂O₅, CoO, CeO₂, ZnO und Oxide des Mangans als Dotierungen, BaTiO₃ + CaZrO₃ und Zugaben von MnO₂, MgO und Seltenerdoxiden, (Ba,Ca)TiO₃ + Nb₂O₅, Co₂O₃ oder MnO₂, Ba₂Ti₉O₂₀, Ba₂Ti₉₋ₓZrₓO₂₀ (0 ≤ x ≤ 1) mit und ohne Mn-Dotierungen, BaTi₅O₁₁, BaTi₄O₉, CaₓSm_{y}Ti_{z}Oₙ (0 < x ≤ 1, 0 ≤ y ≤ 1, 0 ≤ z ≤ 1, 0 ≤ n ≤ 1), Zr(Ti,Sn)O₄, TiO₂, Ta₂O₅, (Ta₂O₅)ₓ-(Al₂O₃)₁₋ₓ (0 ≤ x ≤ 1), (Ta₂O₅)ₓ-(TiO₂)₁₋ₓ (0 ≤ x ≤ 1), (Ta₂O₅)ₓ-(Nb₂O₅)₁₋ₓ (0 ≤ x ≤ 1), (Ta₂O₅)ₓ-(SiO₂)₁₋ₓ (0 ≤ x ≤ 1), BaO-PbO-Nd₂O₃-TiO₂, Ba(Zn,Ta)O₃, BaZrO₃, CaZrO₃, Nd₂Ti₂O₇, (Ba,Ca,Sr)(Ti,Zr)O₃ + Li₂O, SiO₂ und B₂O₃, [Bi₃(Ni₂Nb)O₉]₁₋ₓ (Bi₂(ZnNb_{2(1+d)y}O_{3+6y+5yd})ₓ (0 ≤ x ≤ 1, 0.5 ≤ y ≤ 1.5, -0.05 ≤ d ≤ 0.05), PbNb_{4/5x}((Zr_{0.6}Sn_{0.4})_{1-y}Ti_{y}))₁₋ₓO₃ (0 ≤ x ≤ 0.9, 0 ≤ y ≤ 1), [Pb(Mg_{1/3}Nb_{2/3})O₃]ₓ-(PbTiO₃)₁₋ₓ (0 ≤ x ≤ 1), (Pb,Ba,Sr) (Mg_{1/3}Nb_{2/3})ₓTi_{y}(Zn_{1/3}Nb_{2/3})_{1-x-y}O₃ (0 ≤ x ≤ 1, 0 ≤ y ≤ 1, x+y ≤ 1),
i) Pb(Mg_{0.5}W_{0.5})O₃
ii) Pb(Fe_{0.5}Nb_{0.5})O₃
iii) Pb(Fe_{2/3}W_{1/3})O₃
iv) Pb(Ni_{1/3}Nb_{2/3})O₃
v) Pb(Zn_{1/3}Nb_{2/3})O₃
vi) Pb(Sc_{0.5}Ta_{0.5})O₃
sowie Kombinationen der Verbindungen i) bis vi) mit PbTiO₃ und/oder Pb(Mg_{1/3}Nb_{2/3})O₃ mit und ohne Bleiüberschuß enthalten, während die Dielektrikumschichten mit einer Dielektrizitätskonstante von K > 3 zum Beispiel aus Si₃N₄, SiO₂, SiₓN_{y}O_{z} (0 ≤ x ≤ 1, 0 ≤ y ≤ 1, 0 ≤ z ≤ 1), Al₂O₃, Ta₂O₅, (Ta₂O₅)ₓ-(Al₂O₃)₁₋ₓ (0 ≤ x ≤ 1), (Ta₂O₅)ₓ-(TiO₂)₁₋ₓ (0 ≤ x ≤ 1), (Ta₂O₅)ₓ-(Nb₂O₅)₁₋ₓ (0 ≤ x ≤ 1), (Ta₂O₅)ₓ-(SiO₂)₁₋ₓ (0 ≤ x ≤ 1), TiO₂, SrZrₓTi₁₋ₓO₃ (0 ≤ x ≤ 1) mit und ohne Mn-Dotierungen, CaOₓZnO_{y}(Nb₂O₅)₂ (x = 0.01 bis 0.05, y = 0.43 bis 0.55, z = 0.44 bis 0.52), (BaTiO₃)_{0.18 bis 0.27} + (Nd₂O₃)_{0.316 bis 0.355} + (TiO₂)_{0.276 bis 0.355} + (Bi₂O₃)_{0.025 bis 0.081} + x ZnO, CaTiO₃ + CaTiSiO₅, (Sr,Ca)(Ti,Zr)O₃, (Sr,Ca,M)(Ti,Zr)O₃ (M = Mg oder Zn), (Sr,Ca,Mg,Zn)(Ti,Zr,Si)O₃, (Sr,Ca,Cu,Mn,Pb)TiO₃ + Bi₂O₃, BaO-TiO₂-Nd₂O₃-Nb₂O₅, Zr(Ti,Sn)O₄, BaO-PbO-Nd₂O₃-TiO₂, Ba(Zn,Ta)O₃, BaZrO₃, Ba₂Ti₉O₂₀, Ba₂Ti₉₋ₓZrₓO₂₀ (0 ≤ x ≤ 1) mit und ohne Mn-Dotierungen, BaTi₅O₁₁, BaTi₄O₉, CaₓSm_{y}Ti_{z}Oₙ (0 ≤ x ≤ 1, 0 ≤ y ≤ 1, 0 ≤ z ≤ 1, 0 ≤ n ≤ 1), [Bi₃(Ni₂Nb)O₉]₁₋ₓ-(Bi₂(ZnNb_{2(1+d)y}O_{3+6y+5yd})ₓ (0 ≤ x ≤ 1, 0.5 ≤ y ≤ 1.5, -0.05 ≤ d ≤ 0.05), CaZrO₃ oder Nd₂Ti₂O₇ sind. Außerdem sind an gegenüberliegenden Seiten des Mehrkomponenten-Bauteiles Stromzuführungen 8 befestigt. Als Stromzuführung 8 kann ein galvanischer SMD-Endkontakt aus beispielsweise Cr/Cu, Ni/Sn oder Cr/Cu, Cu/Ni/Sn oder Cr/Ni, Pb/Sn oder ein Bump-end-Kontakt oder eine Kontaktfläche eingesetzt werden. Der Kontakt zwischen der dritten Elektrode 17 mit der ersten Elektrode 13 wird hergestellt, indem vor dem Aufbringen des Materials für die dritte Elektrode 17 Teile der Dielektrikumschichten 14 und 16 auf einer Seite des Mehrkomponenten-Bauteiles beispielsweise durch Ätzen entfernt werden. Beim Aufbringen des Materials für die dritte Elektrode 17 wird ein Kontakt mit der freiliegenden ersten Elektrode 13 hergestellt.

Alternativ kann über dem gesamten Mehrkomponenten-Bauteil eine Schutzschicht aufgebracht werden, die ein anorganisches Material wie beispielsweise Si₃N₄ oder SiO₂ und/oder ein organisches Material wie zum Beispiel Polyimid oder Polybenzocyclobuten enthält.

Außerdem kann auf der Schutzschicht eine Glasschicht oder Glasplatte aufgebracht werden.

Der Kontakt zwischen der dritten Elektrode 17und der ersten Elektrode 13 kann auch über ein Via durch die Dielektrikumschichten 14 und 16 mittels Aluminium, Aluminium dotiert mit Kupfer, Kupfer, Platin oder Nickel hergestellt werden.

### Ausführungsbeispiel 1

Auf einer Substratschicht 1 aus Glas ist eine Barriereschicht 2 aus TiO₂ und eine Widerstandsschicht 3 aus Ti (10 bis 20 nm)/Pt (20 bis 600nm) aufgebracht. Auf diese Widerstandsschicht 3 folgt eine Dielektrikumschicht 4 aus Pb(Zr_{0.53}Ti_{0.47})O₃ mit 5 % Lanthan-Dotierung und auf dieser Dielektrikumschicht 4 befindet sich eine erste Elektrode 5 aus Pt. Auf der ersten Elektrode 5 ist eine weitere Dielektrikumschicht 6 aus Si₃N₄ aufgebracht, auf der eine zweite Elektrode 7 aus Al dotiert mit Cu befestigt ist. Außerdem sind an beiden Seiten des Mehrkomponenten-Bauteils Cr/Cu, Ni/Sn Endkontakte 8 befestigt. Die Widerstandsschicht 3 und die zweite Elektrode 7 sind über ein Via 9 in den Dielektrikumschichten 4 und 6 mittels Aluminium dotiert mit Cu verbunden. Über dem Mehrkomponenten-Bauteil ist eine Schutzschicht aus Si₃N₄ und Polyimid aufgebracht.

### Ausführungsbeispiel 2:

Auf einer Substratschicht 1 aus Al₂O₃ mit einer Planarisierung aus Glas ist eine Barriereschicht 2 aus Al₂O₃ und eine Widerstandsschicht 3 aus Ti (10 bis 20 nm)/Pt (20 bis 600 nm) aufgebracht. Auf diese Widerstandsschicht 3 folgt eine Dielektrikumschicht 4 aus Pb(Zr_{0.53}Ti_{0.47})O₃ mit 5 % Lanthan-Dotierung. Auf diese Dielektrikumschicht 4 wird eine erste Elektrode 5 aus Pt (50 nm bis 1 µm) aufgebracht und widerstandsschichtähnlich strukturiert. Auf die erste Elektrode 5 wurde eine weitere Dielektrikumschicht 6 aus Si₃N₄ aufgebracht. Auf die Dielektrikumschicht 6 wurde eine zweite Elektrode 7 aus Aluminium mit Kuperdotierung abgeschieden. Auf die zweite Elektrode 7 ist eine weitere Dielektrikumschicht 10 aus Si₃N₄ aufgebracht. Auf die Dielektrikumschicht 10 wird eine dritte Elektrode 11 aus Aluminium dotiert mit Kuper abgeschieden. Über Vias 9 und 12 in den Dielektrikumschichten 4 und 6 bzw. 6 und 10 werden die Widerstandsschicht 3 und zweite Elektrode 7 sowie die erste Elektrode 5 und die dritte Elektrode 11 mittels Al dotiert mit Cu verbunden. Außerdem sind an beiden Seiten des Mehrkomponenten-Bauteiles Cr/Cu, Ni/Sn Endkontakte 8 angebracht. Über dem Mehrkomponenten-Bauteil ist eine Schutzschicht aus Si₃N₄ und Polyimid aufgebracht.

### Ausführungsbeispiel 3

Auf einer Substratschicht 1 aus Glas ist eine Barriereschicht 2 aus TiO₂ und eine erste Elektrode 13 aus Ti (10 bis 20 nm)/Pt (20 bis 600nm) aufgebracht. Auf diese erste Elektrode 13 folgt eine Dielektrikumschicht 14 aus Pb(Zr_{0.53}Ti_{0.47})O₃ mit 5 % Lanthan-Dotierung und auf dieser Dielektrikumschicht 14 befindet sich eine zweite Elektrode 15 aus Pt. Auf der zweiten Elektrode 15 ist eine weitere Dielektrikumschicht 16 aus Pb(Zr_{0.53}Ti_{0.47})O₃ mit 5 % Lanthan-Dotierung aufgebracht, auf der eine dritte Elektrode 17 aus Pt befestigt ist. Außerdem sind an beiden Seiten des Mehrkomponenten-Bauteils Cr/Cu, Ni/Sn Endkontakte 8 befestigt. Vor dem Auftragen des Materials für die dritte Elektrode 17 sind Teile der Dielektrikumschichten 14 und 16 auf einer Seite des Bauteiles beispielsweise durch Ätzen entfernt worden. Beim Aufbringen der dritten Elektrode 17 wurde diese mit der freiliegenden ersten Elektrode 13 kontaktiert. Über dem Mehrkomponenten-Bauteil ist eine Schutzschicht aus Si₃N₄ und Polyimid aufgebracht.

## Patentansprüche

1. Elektronisches Mehrkomponenten-Bauteil mit wenigstens einer ersten und einer zweiten Stromzuführung (8),
sowie einer Substratschicht (1),
einer darüberliegenden Widerstandsschicht (3), welche in Verbindung mit der ersten Stromzuführung steht,
wenigstens einer darüberliegenden Dielektrikumsschicht (4),
und wenigstens einer darüberliegenden ersten Elektrode (5), welche mit der zweiten Stromzuführung verbunden ist.

2. Elektronisches Mehrkomponenten-Bauteil nach Anspruch 1,
**dadurch gekennzeichnet,**
**daß** auf der ersten Elektrode (5) eine weitere Dielektrikumschicht (6) und eine zweite Elektrode (7), welche mit der ersten Stromzuführung verbunden ist, aufgebracht sind.

3. Elektronisches Mehrkomponenten-Bauteil nach Anspruch 2,
**dadurch gekennzeichnet,**
**daß** die zweite Elektrode (7) mit der Widerstandsschicht (3) verbunden ist.

4. Elektronisches Mehrkomponenten-Bauteil nach Anspruch 1,
**dadurch gekennzeichnet,**
**daß** auf der ersten Elektrode (5) eine zweite (6) und dritte Dielektrikumschicht (10) und eine zweite (7) und dritte (11) Elektrode alternierend aufgebracht sind, wobei die zweite Elektrode (7) mit der ersten Stromzuführung und die dritte Elektrode (11) mit der zweiten Stromzuführung in Verbindung steht.

5. Elektronisches Mehrkomponenten-Bauteil nach Anspruch 4,
**dadurch gekennzeichnet,**
**daß** die zweite Elektrode (7) mit der Widerstandsschicht (3) und die dritte Elektrode (11) mit der ersten Elektrode (5) verbunden ist.

6. Elektronisches Mehrkomponenten-Bauteil nach Anspruch 1 bis 5,
**dadurch gekennzeichnet,**
**daß** die Widerstandsschicht (3) aus einem Material mit einem Metall oder einer Legierung oder einem leitenden Oxid oder einem Metall und einer Legierung oder einem Metall und einem leitenden Oxid oder einem Metall, einer Legierung und einem leitenden Oxid oder einem leitenden Metallnitrid ist.

7. Elektronisches Mehrkomponenten-Bauteil nach Anspruch 1 bis 5,
**dadurch gekennzeichnet,**
**daß** die Elektroden (5, 7, 11) widerstandsbehaftet und aus einem Material mit einem Metall oder einer Legierung oder einem leitenden Oxid oder einem Metall und einer Legierung oder einem Metall und einem leitenden Oxid oder einem Metall, einer Legierung und einem leitenden Oxid oder einem leitenden Metallnitrid sind.

8. Elektronisches Mehrkomponenten-Bauteil nach Anspruch 1 bis 5,
**dadurch gekennzeichnet,**
**daß** die über der Widerstandsschicht (3) liegende erste Dielektrikumschicht (4) eine Dielektrizitätskonstante von K > 7 aufweist.

9. Elektronisches Mehrkomponenten-Bauteil nach Anspruch 3 bis 5,
**dadurch gekennzeichnet,**
**daß** die zweite (6) und dritte Dielektrikumschicht (10) eine Dielektrizitätskonstante von K > 3 besitzen.

10. Elektronisches Mehrkomponenten-Bauteil mit wenigstens einer ersten und einer zweiten Stromzuführung (8),
sowie einer Substratschicht (1),
wenigstens einer darüberliegenden ersten Elektrode (13), welche mit der ersten Stromzuführung verbunden ist,
und darüberliegend wenigstens eine erste und zweite Dielektrikumschicht (14, 16) alternierend mit wenigstens einer zweiten und dritten Elektrode (15, 17), wobei die zweite Elektrode (15) mit der zweiten Stromzuführung und die dritte Elektrode (17) mit der ersten Stromzuführung verbunden ist.

11. Elektronisches Mehrkomponenten-Bauteil nach Anspruch 10,
**dadurch gekennzeichnet,**
**daß** die erste und zweite Dielektrikumschicht (14, 16) jeweils aus einem dielektrischen Material mit gleichen dielektrischen Eigenschaften sind.

12. Elektronisches Mehrkomponenten-Bauteil nach Anspruch 10,
**dadurch gekennzeichnet,**
**daß** die erste und zweite Dielektrikumschicht (14, 16) aus dielektrischen Materialien mit unterschiedlichen dielektrischen Eigenschaften bestehen, wobei die Dielektrizitätskonstante der ersten Dielektrikumschicht (14) größer als die Dielektrizitätskonstante der zweiten Dielektrikumschicht (16) ist.

13. Elektronisches Mehrkomponenten-Bauteil nach Anspruch 1 bis 5 und 10,
**dadurch gekennzeichnet,**
**daß** die Substratschicht (1) ein keramisches Material, ein keramisches Material mit einer Planarisierung aus Glas, ein glaskeramisches Material, ein Glasmaterial oder Silicium enthält.

14. Elektronisches Mehrkomponenten-Bauteil nach Anspruch 1 bis 5 und 10,
**dadurch gekennzeichnet,**
**daß** die Elektroden (5, 7, 11, 13, 15, 17) aus einem Material mit einem Metall oder einer Legierung oder einem leitenden Oxid oder einem Metall und einer Legierung oder einem Metall und einem leitenden Oxid oder einem Metall, einer Legierung und einem leitenden Oxid oder einem leitenden Metallnitrid sind.

15. Elektronisches Mehrkomponenten-Bauteil nach Anspruch 1 bis 5 und 10,
**dadurch gekennzeichnet,**
**daß** die Stromzuführung (8) ein galvanischer SMD-Endkontakt oder ein Bump-end-Kontakt oder eine Kontaktfläche ist.

16. Elektronisches Mehrkomponenten-Bauteil nach Anspruch 1 bis 5 und 10,
**dadurch gekennzeichnet,**
**daß** sich auf der Substratschicht (1) eine Barriereschicht (2) befindet.

17. Elektronisches Mehrkomponenten-Bauteil nach Anspruch 1 bis 5 und 10,
**dadurch gekennzeichnet,**
**daß** über dem gesamten Mehrkomponenten-Bauteil eine Schutzschicht aus einem anorganischen und/oder einem organischen Material aufgebracht ist.

18. Elektronisches Mehrkomponenten-Bauteil nach Anspruch 1 bis 5 und 10,
**dadurch gekennzeichnet,**
**daß** auf der Schutzschicht eine Glasschicht oder eine Glasplatte aufgebracht ist.

## Claims

1. An electronic multi-component unit with at least a first and a second current supply contact (8),
a substrate layer (1),
a resistance layer (3) disposed thereon and connected to the first current supply contact,
at least one dielectric layer (4) disposed over the resistance layer, and
at least a first electrode (5) disposed thereon and connected to the second current supply.

2. An electronic multi-component unit as claimed in claim 1, **characterized in that** a further dielectric layer (6) and a second electrode (7) which is connected to the first current supply contact are provided on the first electrode (5).

3. An electronic multi-component unit as claimed in claim 2, **characterized in that** the second electrode (7) is connected to the resistance layer (3).

4. An electronic multi-component unit as claimed in claim 1, **characterized in that** a second (6) and a third dielectric layer (10) and a second (7) and a third electrode (11) are provided in an alternating arrangement on the first electrode (5), such that the second electrode (7) is connected to the first current supply contact and the third electrode (11) is connected to the second current supply contact.

5. An electronic multi-component unit as claimed in claim 4, **characterized in that** the second electrode (7) is connected to the resistance layer (3) and the third electrode (11) is connected to the first electrode (5).

6. An electronic multi-component unit as claimed in claims 1 to 5, **characterized in that** the resistance layer (3) is made from a material comprising a metal, or an alloy, or a conductive oxyde, or a metal and an alloy, or a metal and a conductive oxyde, or a metal, an alloy and a conductive oxyde, or a conductive metal nitride.

7. An electronic multi-component unit as claimed in claims 1 to 5, **characterized in that** the electrodes (5, 7, 11) have a resistance value and that they are made from a material comprising a metal, or an alloy, or a conductive oxyde, or a metal and an alloy, or a metal and a conductive oxyde, or a metal, an alloy and a conductive oxyde, or a conductive metal nitride.

8. An electronic multi-component unit as claimed in claims 1 to 5, **characterized in that** the first dielectric layer (4) disposed over the resistance layer (3) has a dielectric constant value of K > 7.

9. An electronic multi-component unit as claimed in claims 3 to 5, **characterized in that** the second (6) and third (10) dielectric layers have dielectric constant values of K > 3.

10. An electronic multi-component unit with at least a first and a second current supply contact,
a substrate layer (1),
at least a first electrode (13) disposed thereon and connected to the first current supply contact,
and disposed thereon at least a first and a second dielectric layer (14, 16) in an alternating arrangement with at least a second and a third electrode (15, 17), the second electrode (15) being connected to the second current supply contact and the third electrode (17) to the first current supply contact.

11. An electronic multi-component unit as claimed in claim 10, **characterized in that** the first and the second dielectric layer (14, 16) are both made from a dielectric material having the same dielectric properties.

12. An electronic multi-component unit as claimed in claim 10, **characterized in that** that the first and the second dielectric layer (14, 16) are made from dielectric materials which have different dielectric properties, the dielectric constant of the first dielectric layer (14) being greater than the dielectric constant of the second dielectric layer (16).

13. An electronic multi-component unit as claimed in claims 1 to 5 and 10, **characterized in that** the substrate layer (1) comprises a ceramic material, a ceramic material with a glass planarization, a glass-ceramic material, a glass material, or silicon.

14. An electronic multi-component unit as claimed in claims 1 to 5 and 10, **characterized in that** the electrodes (5, 7, 11, 13, 15, 17) are made from a material comprising a metal, or an alloy, or a conductive oxyde, or a metal and an alloy, or a metal and a conductive oxyde, or a metal, an alloy and a conductive oxyde, or a conductive metal nitride.

15. An electronic multi-component unit as claimed in claims I to 5 and 10, **characterized in that** the current supply contact (8) is an electroplated SMD end contact or a bump end contact or a contact surface.

16. An electronic multi-component unit as claimed in claims 1 to 5 and 10, **characterized in that** a barrier layer (2) is present on the substrate layer (3).

17. An electronic multi-component unit as claimed in claims 1 to 5 and 10, **characterized in that** a protective layer of an inorganic and/or organic material is disposed over the entire multi-component unit.

18. An electronic multi-component unit as claimed in claims 1 to 5 and 10, **characterized in that** a glass layer or a glass plate is provided on the protective layer.

## Revendications

1. Composant électronique à plusieurs éléments, présentant au moins une première et une deuxième alimentation en courant (8),
ainsi qu'une couche de substrat (1),
une couche formant une résistance (3) disposée sur celle-ci, qui est raccordée à la première alimentation en courant,
au moins une couche diélectrique (4) disposée sur celle-ci,
et au moins une première électrode (5) sur celle-ci, qui est raccordée à la deuxième alimentation en courant.

2. Composant électronique à plusieurs éléments selon la revendication 1, **caractérisé en ce que** sont appliquées sur la première électrode (5) une autre couche diélectrique (6) et une deuxième électrode (7), qui est reliée à la première alimentation en courant.

3. Composant électronique à plusieurs éléments selon la revendication 2, **caractérisé en ce que** la deuxième électrode (7) est raccordée à la couche formant une résistance (3).

4. Composant électronique à plusieurs éléments selon la revendication 1, **caractérisé en ce que** sur la première électrode (5) sont appliquées une deuxième (6) et une troisième couche diélectrique (10) et, en alternance, une deuxième (7) et une troisième électrode (11), la deuxième électrode (7) étant raccordée à la première alimentation en courant et la troisième électrode (11) à la deuxième alimentation en courant.

5. Composant électronique à plusieurs composants selon la revendication 4, **caractérisé en ce que** la deuxième électrode (7) est raccordée à la couche formant une résistance (3) et la troisième électrode (11) à la première électrode (5).

6. Composant électronique à plusieurs éléments selon les revendications 1 à 5, **caractérisé en ce que** la couche formant une résistance (3) est constituée par un matériau avec un métal ou un alliage ou un oxyde conducteur ou un métal et un alliage ou un métal et un oxyde conducteur ou un métal, un alliage et un oxyde conducteur ou un nitrure de métal conducteur.

7. Composant électronique à plusieurs éléments selon les revendications 1 à 5, **caractérisé en ce que** les électrodes (5, 7, 11) forment une résistance et sont constituées par un matériau avec un métal ou un alliage ou un oxyde conducteur ou un métal et un alliage ou un métal et un oxyde conducteur ou un métal, un alliage et un oxyde conducteur ou un nitrure de métal conducteur.

8. Composant électronique à plusieurs éléments selon les revendications 1 à 5, **caractérisé en ce que** la première couche diélectrique (4) située sur la couche formant une résistance (3) présente une constante diélectrique K > 7.

9. Composant électronique à plusieurs éléments selon les revendications 3 à 5, **caractérisé en ce que** la deuxième (6) et la troisième couche diélectrique (10) présentent une constante diélectrique K > 3.

10. Composant électronique à plusieurs éléments, présentant au moins une
première et une deuxième alimentation en courant (8),
ainsi qu'une couche de substrat (1),
au moins une première électrode (13) disposée sur celle-ci, qui est raccordée à la première alimentation en courant,
et sur celle-ci au moins une première et une deuxième couche diélectrique (14, 16) en alternance avec au moins une deuxième et une troisième électrode (15, 17), la deuxième électrode (15) étant raccordée à la deuxième alimentation en courant et la troisième électrode (17) étant raccordée à la première alimentation en courant.

11. Composant électronique à plusieurs éléments selon la revendication 10, **caractérisé en ce que** la première et la deuxième couche diélectrique (14, 16) sont à chaque fois constituées par un matériau diélectrique présentant les mêmes propriétés diélectriques.

12. Composant électronique à plusieurs éléments selon la revendication 10, **caractérisé en ce que** la première et la deuxième couche diélectrique (14, 16) sont constituées par des matériaux diélectriques présentant des propriétés diélectriques différentes, la constante diélectrique de la première couche diélectrique (14) étant supérieure à la constante diélectrique de la deuxième couche diélectrique (16).

13. Composant électronique à plusieurs composants selon les revendications 1 à 5 et 10, **caractérisé en ce que** la couche de substrat (1) contient un matériau céramique, un matériau céramique avec une planarisation en verre, un matériau en céramique de verre, un matériau à base de verre ou du silicium.

14. Composant électronique à plusieurs éléments selon les revendications 1 à 5 et 10, **caractérisé en ce que** les électrodes (5, 7, 11, 13, 15, 17) sont constituées par un matériau avec un métal ou un alliage ou un oxyde conducteur ou un métal et un alliage ou un métal et un oxyde conducteur ou un métal, un alliage et un oxyde conducteur ou un nitrure de métal conducteur.

15. Composant électronique à plusieurs composants selon les revendications 1 à 5 et 10, **caractérisé en ce que** l'alimentation en courant (8) est un contact d'extrémité SMD galvanisé ou un plot de contact d'extrémité ou une surface de contact.

16. Composant électronique à plusieurs éléments selon les revendications 1 à 5 et 10, **caractérisé en ce qu'**une couche formant une barrière (2) se trouve sur la couche de substrat (1).

17. Composant électronique à plusieurs composants selon les revendications 1 à 5 et 10, **caractérisé en ce que** sur la totalité du composant à plusieurs éléments est appliquée une couche de protection en un matériau inorganique et/ou organique.

18. Composant électronique à plusieurs éléments selon les revendications 1 à 5 et 10, **caractérisé en ce que** sur la couche de protection est appliquée une couche ou une plaque en verre.
